# EUROPEAN PATENT SPECIFICATION

(11) **EP 0 526 749 B1**
(45) Date of publication and mention of the grant of the patent: **28.10.1998**
(21) Application number: 92111606.7
(22) Date of filing: 08.07.1992
(51) Int. Cl.: H01M 8/12, H01M 4/86

(54) **A cermet electrode and a method of manufacturing the same**
Cermet-Elektrode und Verfahren zu ihrer Herstellung
Electrode en cermet et procédé de sa fabrication

(30) Priority: 06.08.1991 JP 196851/91
(43) Date of publication of application: 10.02.1993
(73) Proprietor: OSAKA GAS CO., LTD., Osaka-shi, Osaka-fu 541 (JP)
(72) Inventor: Ipponmatsu, Masamichi, Nishinomiya, Hyogo (JP); Suzuki, Minoru, Osaka (JP); Sasaki, Hirokazu, Toyonaka, Osaka (JP); Otoshi, Shoji, Sakai, Osaka (JP)
(74) Representative: Strehl Schübel-Hopf & Partner

(56) References cited:
- EP-A- 0 171 910
- EP-A- 0 196 388
- EP-A- 0 329 890
- EP-A- 0 441 329
- FR-A- 1 513 898
- GB-A- 2 054 163
- PROCEEDINGS OF THE 2nd INTERNATL. SYMPOSIUM ON SOLID OXIDE FUEL CELLS, 02-05 July 1991, Athens (GR), EUR 13564; M. SUZUKI et al., pp. 58585-58591
- JOURNAL OF THE ELECTROCHEMICAL SOCIETY, vol. 139, no. 1, 1992; SASAKI et al., pp. L12-L13

## Description

### BACKGROUND OF THE INVENTION

This invention relates to a cermet electrode for use as e.g. the fuel electrode of a solid electrolyte fuel cell, and to a method of manufacturing the same.

A cermet electrode comprising grains of at least one of nickel, cobalt, iron and their alloys in which a framework structure of doped zirconia has been grown by electrochemical vapor deposition (e.g. Japanese Kokai Patent Publication Nos. 62-296366 and 62-281271), as well as a method for manufacturing such an electrode, are already known.

However, since the operating temperature of a solid electrolyte fuel cell is as high as about 1,000°C, any cermet electrode incorporating nickel, cobalt or iron experiences sintering of the metal grains in the passage of a large current (not less than 2A/cm²) or in long-term use, which leads to shrinkage and a decrease in reactive surface area, resulting in aging of performance.

To overcome the above disadvantage, it may be contemplated to manufacture a cermet electrode of improved life and electrode activity by employing a high-melting metal having a melting point of not lower than 1,900°C, such as ruthenium, but since such a high-melting metal is poor in sinterability, any cermet electrode sintered at a temperature up to 1,200°C has the drawback of low electrical conductivity in planar (crosswise) direction.

From Proceedings of the Second International symposium on Solid Oxide Fuel Cells, 2nd-5th July 1991, Athens, Greece, pp 585-591, Suzuki et al, a cermet electrode comprising ruthenium and yttria-stabilized zirconia is known.

### SUMMARY OF THE INVENTION

The object of this invention is to provide a cermet electrode which is satisfactory not only in useful life and electrode activity but also in electrical conductivity and a method of manufacturing the same.

This object is met by a cermet electrode according to claim 1 and a method of manufacturing a cermet electrode according claim 4. Preferred embodiments are disclosed in the dependant claims.

The cermet electrode of the invention comprises grains of a high-melting metal element with a melting point of not lower than 1,900°C and/or grains of an alloy containing said high-melting metal as secured with zirconia which is doped to present the form of a cubic lattice.

The high-melting metal and the alloy containing said high-melting metal is so resistant to sintering that the ageing of performance due to sintering can be completely inhibited to insure satisfactory useful life and electrode activity. Moreover, because grains of the high-melting metal and/or its alloy are secured in position by zirconia doped to present the form of a cubic grating, the bond between the grains and the zirconia is improved to provide an increased ternary interfacial dimension contributory to electrode reaction and reduce polarizations.

The high-melting metal is preferably at least one member selected from the group consisting of ruthenium (Ru, m.p. 2,500°C), osmium (Os, m.p. 2,700°C), rhodium (Rh, m.p. 1,960°C), iridium (Ir, m.p. 2,443°C) and tungsten (W, m.p. ca. 3,380°C). Among them, ruthenium is particularly beneficial in terms of stability in a reducing atmosphere and cost.

Preferred species of the metal forming said alloy with such a high-melting metal are nickel, iron and cobalt.

While zirconia can be doped with yttria, calcia, ytterbia, scandium oxide or the like, yttria-doped zirconia is preferred.

In the manufacture of a cermet electrode of the invention, grains of a high-melting metal having a melting point of not lower than 1,900°C and/or grains of an alloy containing said high-melting metal are disposed over a support such as a doped zirconia electrolyte and a framework structure of doped zirconia is caused to grow around said grains by electrochemical vapor deposition to secure said grains in position and to said support.

In the -electrochemical vapor deposition process, a gas-phase migration of atoms of the high-melting metal occurs through the vapor of the high-melting metal chloride formed on exposure to the vapor of a chloride, such as zirconium chloride, or a chlorine-containing atmosphere, whereby the growth of necks between the grains of said high-melting metal and/or alloy thereof is promoted to improve the electrical conductivity in planar (crosswise) direction of the cermet electrode.

The grains of said high-melting metal or alloy thereof are grains with an average diameter of not greater than 10 µm. The use of nickel, cobalt or iron in the conventional technology tends to cause sintering and, therefore, the grain size cannot be reduced much. In accordance with this invention, it is possible to employ grains having an average diameter of not greater than 10 µm and, thus, insure a large reaction interface and, hence, an electrode having increased electrode reaction activity.

The cermet electrode of this invention is very satisfactory not only in useful life and electrode activity but also in electrical conductivity. Therefore, when the cermet electrode is operated as a fuel electrode in a solid electrolyte fuel cell, the internal resistance of the fuel cell is decreased and the generated current is increased in density. Moreover, because there is no sacrifice of performance due to sintering, the electrode withstands high-output operation and promises a long serviceable life.

Since the electrochemical vapor deposition technique is utilized, there occurs a gas-phase migration of atoms of the high-melting metal through the vapor of the high-melting metal chloride formed upon exposure to the vapor of a chloride, such as zirconium chloride, or a chlorine-containing atmosphere, with the result that the growth of necks occurs between grains of the high-melting metal and/or its alloy to improve the electrical conductivity in planar (crosswise) direction of the cermet electrode.

### DETAILED DESCRIPTION OF THE PREFERRED EMBODIMENTS

The following working and comparative examples are intended to describe this invention in further detail and should by no means be construed as defining the scope of the invention.

### Example 1

A porous self-supporting cylindrical air electrode, 15 mm in outer diameter and having one end closed, as formed from a strontium-doped lanthanum manganate (La_{0.81}Sr_{0.09}MnO_{3±δ}) was coated with yttria-doped zirconia (film thickness: ca. 15 µm), an electrolyte, by the electrochemical vapor deposition technique.

Then, an aqueous slurry containing a ruthenium metal powder with a grain size of 2-3 µm (ruthenium: water:polyvinyl alcohol (binder) = 40:58:2, by weight) was coated on the above yttria-doped zirconia film and dried at room temperature. Then, electrochemical vapor deposition with yttria-doped zirconia was carried out in an argon (Ar) gas atmosphere containing chlorine gas, yttrium chloride (YCl₃) and zirconia chloride (ZrCl₄).

When the solid electrolyte fuel cell thus fabricated was operated with hydrogen/oxygen at 1,000°C, the generated current was 2.5 A/cm² at 0.6 V. When the endurance test was performed at a generated current of 2.5 A/cm², no voltage drop was observed at all even after 1,000 hours and rather the voltage rose by 3%. When the resistance in planar direction of the cermet electrode was measured by the 4-terminal method, the resistance value was 0.00036 Ω cm at 1,000°C.

### Comparative Example 1

Without using the electrochemical vapor deposition technique, a ruthenium metal powder and an yttria-doped zirconia powder were admixed in a mol ratio of 10:1 and the mixture was sintered at 1,000°C to give a fuel electrode. This fuel electrode was used to fabricate a solid electrolyte fuel cell. Then, a generation experiment was carried out in the same manner as Example 1. The generated current was 830 mA/cm² at 0.6 V. The resistance in planar direction of the cermet electrode was 0.0018 Ω cm at 1,000°C.

It is apparent from Example 1 and Comparative Example 1 that the use of a ruthenium cermet electrode manufactured by the electrochemical vapor deposition technique resulted in a marked increase in generating capacity.

### Example 2

A porous self-supporting cylindrical air electrode, 15 mm in outer diameter and having one end closed, as formed from a strontium-doped lanthanum manganate (La_{0.81}Sr_{0.09}MnO_{3±δ}) was dipped in an aqueous slurry containing an yttria-doped zirconia powder with a grain size of about 0.1 µm (polyvinyl alcohol added as a binder) and a coating film with a thickness of about 30 µm was prepared by the vacuum suction technique, followed by sintering in the air at 1,300°C.

Then, an aqueous slurry containing a ruthenium metal powder with a grain size of 2 to 3 µm (ruthenium:water:polyvinylalcohol (binder) = 40:58:2, by weight) was coated on the above yttria-doped zirconia film and dried at room temperature. Then, electrochemical vapor deposition with yttria-doped zirconia was carried out in an argon (Ar) atmosphere containing chlorine gas, yttrium chloride (YCl₃) and zirconium chloride (ZrCl₄).

When a solid electrolyte fuel cell fabricated in the above manner was operated with hydrogen/oxygen at 1,000°C, the generated current was 1.8 A/cm² at 0.6 V.

### Example 3

The fabrication of an electrode and the power generation test were carried out in the same manner as Example 1 except that a rhodium metal powder was used in lieu of the ruthenium metal powder. The generating capacity of the fuel cell was about 2.2 A/cm² at 0.6 V. The resistance in planar direction of the cermet electrode was 0.00056 Ω cm.

### Example 4

The fabrication of an electrode and the power generation test were performed under the same conditions as in Example 1 except that an alloy powder consisting of 70 wt.% nickel and 30 wt.% of ruthenium (average grain size: 5 µm) was used in lieu of the ruthenium metal powder. The generating capacity of the fuel cell was about 1.5 A/cm² at 0.6 V and the resistance in planar direction of the cermet electrode was 0.00031 Ω cm.

## Claims

1. A cermet electrode comprising grains of a high-melting metal having a melting point of not lower than 1,900°C and/or grains of an alloy containing said high-melting metal, said grains having an average diameter of not larger than 10 µm and being formed by electrochemical vapor deposition to be secured in position with zirconia which is doped to present the form of a cubic lattice.

2. The cermet electrode according to claim 1, wherein said high-melting metal is at least one member selected from the group consisting of ruthenium, osmium, rhodium, iridium and tungsten.

3. The cermet electrode according to claim 1 or 2, wherein said zirconia is doped with yttria.

4. A method of manufacturing a cermet electrode, comprising the steps of covering a support made of doped zirconia with grains of a high-melting metal having a melting point of not lower than 1,900°C and/or grains of an alloy containing said high-melting metal and causing a framework structure to grow from the doped zirconia around said grains by electrochemical vapor deposition to secure said grains in position and to said support.

5. The manufacturing method according to claim 4, wherein the average diameter of said grains of said high-melting metal and/or said grains of said alloy containing said high-melting metal is not greater than 10 µm.

## Patentansprüche

1. Cermet-Elektrode mit Teilchen aus einem hochschmelzenden Metall mit einem Schmelzpunkt von mindestens 1900 °C und/oder Teilchen aus einer dieses hochschmelzende Metall enthaltenden Legierung, wobei die Teilchen einen mittleren Durchmesser von höchstens 10 µm haben und durch elektrochemische Dampfphasenabscheidung gebildet sind, so daß sie durch Zirkondioxid, das so dotiert ist, daß es die Form eines kubischen Gitters aufweist, festgehalten werden.

2. Cermet-Elektrode gemäß Anspruch 1, wobei das hochschmelzende Metall wenigstens eines der Elemente Ruthenium, Osmium, Rhodium, Iridium und Wolfram ist.

3. Cermet-Elektrode gemäß Anspruch 1 oder 2, wobei das Zirkondioxid mit Yttriumdioxid dotiert ist.

4. Verfahren zum Herstellen einer Cermet-Elektrode, wobei man einen Träger aus dotiertem Zirkondioxid mit Teilchen aus einem hochschmelzenden Metall mit einem Schmelzpunkt von mindestens 1900 °C und/oder Teilchen aus einer dieses hochschmelzende Metall enthaltenen Legierung bedeckt und bewirkt, daß durch elektrochemische Dampfphasenabscheidung um eine Gerüststruktur aus dem dotiertem Zirkondioxid die Teilchen herum wächst, um diese in Position und an dem Träger festzuhalten.

5. Herstellverfahren gemäß Anspruch 4, wobei der mittlere Durchmesser der Teilchen des hochschmelzenden Metalls und/oder der Teilchen der das hochschmelzende Metall enthaltenden Legierung höchstens 10 µm beträgt.

## Revendications

1. Electrode en cermet comprenant des grains d'un métal à point de fusion élevé présentant un point de fusion qui n'est pas inférieur à 1900°C et/ou des grains d'un alliage contenant ledit métal à point de fusion élevé, lesdits grains ayant un diamètre moyen ne dépassant pas 10 µm et étant formés par dépôt électrochimique en phase vapeur de manière à être maintenus en place par de la zircone qui est dopée pour présenter la forme d'un réseau cubique.

2. Electrode en cermet selon la revendication 1, dans laquelle ledit métal à point de fusion élevé est au moins un élément choisi dans le groupe constitué par le ruthénium, l'osmium, le rhodium, l'iridium et le tungstène.

3. Electrode en cermet selon la revendication 1 ou 2, dans laquelle la dite zircone est dopée à l'yttria.

4. Procédé de fabrication d'une électrode en cermet, comprenant les étapes consistant à recouvrir un support fait de zircone dopée avec des grains d'un métal à point de fusion élevé présentant un point de fusion qui n'est pas inférieur à 1900°C et/ou des grains d'un alliage contenant ledit métal à point de fusion élevé et à provoquer la croissance d'une structure en treillis à partir de la zircone dopée autour desdits grains par dépôt électrochimique en phase vapeur pour maintenir lesdits grains en place et les fixer audit support.

5. Procédé de fabrication selon la revendication 4, dans lequel le diamètre moyen desdits grains dudit métal à point de fusion élevé et/ou desdits grains dudit alliage contenant ledit métal à point de fusion élevé n'est pas supérieur à 10 µm.
